# EUROPEAN PATENT APPLICATION

(11) **EP 2 711 979 A1**
(43) Date of publication of application: **26.03.2014**
(21) Application number: 12185756.9
(22) Date of filing: 24.09.2012
(51) Int. Cl.: H01L 21/673, H01L 21/67, B28D 5/00

(54) **Wafer cutting system**

(71) Applicant: Meyer Burger AG, 3645 GWATT (Thun) (CH)
(72) Inventor: Wenger, Markus, 3752 Wimmis (CH); Schnyder, Matthias, 3604 Thun (CH); Heiniger, Christoph, 3053 Münchenbuchsee (CH)
(74) Representative: Patentbüro Paul Rosenich AG

(57) **Abstract**

The invention relates to a wafer receiving box (3) for receiving wafers (5), the wafer receiving box (3) having in a first area (11) a width (W1), characterized in that the wafer receiving box (3) has in a further area (12, 13) which is above and/or below said first area portions (6) laterally extending beyond the width (W1) of said first area (11) such that the width (W2) of the wafer receiving box (3) in said further area (12, 13) is larger than the width (W1) of said first area (11).

## Description

The invention refers to a wafer receiving box for receiving wafers, the wafer receiving box having in a first area a width; and to a wafer cutting system for cutting an ingot into a plurality of wafers; and to a wafer cutting method for cutting an ingot into a plurality of wafers.

Wafers e.g. for use in solar cells are cut from a block (also called brick or ingot) in a wire cutting device employing a metal wire and abrasives. Usually abrasives suspended in a slurry, that are transported by a metal wire, are used. Nowadays, wafers are cut more and more often using fixed abrasives, which are directly attached to the metal wire. Such wire is e.g. called a diamond wire. The present invention is not restricted to one of these cutting technologies.

The ingot to be cut may be of poly-crystalline or mono-crystalline semiconductor material, e.g. silicon or other materials such as sapphire. In the latter case, the block is generally referred to as core. The ingot is what is casted. In case of a poly-crystalline material usually a large ingot is casted and bricks are cut from that. In case of a mono-crystalline material a round ingot is pulled and cut into wafers, normally having the typical mono-crystalline wafer shape. Usually, there is a bricking process to cut the slabs away before the wafering process takes place.

From prior art containers are known for receiving a brick already cut into a plurality of individual wafers. When the wafers are still basically in the position they were in before the cut, the wafers are called a wafer block. The containers are used to clean or otherwise treat the wafers.

Prior art is further known, where the block to be cut is attached to a glass plate, which in turn is attached to a fixture attachment. The fixture attachment is horizontally inserted between two guide rails (usually L-shaped). The guide rails are part of the cutting device and only used for inserting the workpiece into the machine. As soon as the workpiece is in position, clamps hold the fixture attachment during cutting. When the cutting process is finished, the wafer block (arrangement of a plurality of more or less parallel wafers) is slid out of the cutting device, while the fixture attachment is supported by the two guide rails.

Due to the fact, that the load is pretty heavy, the relative motion of the guide rails, the fixture attachment and the dirt (slurry) produces friction that is irregular and pretty hard to overcome. Moreover, when moving the block into and more importantly out of the cutting device or during transportation, the wafers wobble (e.g. slip-stick effect). In the case of the inward movement this does not constitute a problem, since the block has not been cut yet. However, when removing said wafer block comprising a plurality of extremely thin wafers, the so called slip-stick effect causes damages to the wafers. The individual wafers tilt easily about the axis formed by the thin attachment zone on the glass plate or the fixture attachment, respectively. This causes adjacent wafers to touch each other. When the wafers however touch each other they may be damaged. Hence the slip-stick effect causes yield loss, resulting in higher costs per wafer.

Wafer receiving boxes are used for removing wafers or wafer bricks from wire saws but also for transporting the wafers to the next processing station. They may even be inserted in the next processing station that than may handle the wafers or bricks automatically.

Wafer carriers for wafers for solar cells are known from the state of the art. They often have (movable) means for holding the wafers, e.g. CN201788957U, DE102005028112A, DE102006052908A, DE102008060012 A1, DE102008060014 A1, DE102008062123 A1, DE102008060012 A1, JP10181880 A and WO2008106913 A2.

JP5220731 A discloses a wafer cutting and separating method, wherein the cutting wire of a wire saw cuts in a horizontal manner when it has reached the beam. The separated wafers are received by wafer receiving box. JP7153724A discloses that the wafers cut from an ingot are received by a cassette after the step of cutting. The distance between the wire guide rollers of the corresponding wire saw is very large such that the cutting quality is adversely effected.

PCT/EP2011/064621 discloses a loading device which is used to move the work piece holder with attached brick and wafer brick in and out of the wire saw, respectively.

Following parameters are a measure for the quality of the wafers:
- Thickness, TTV (Total Thickness Variation = difference of the maximum thickness value and the minimum thickness value of silicon wafers)
- Saw marks (saw marks = grooves on the wafer surfaces, which are generated during the sawing process by a wire saw)
- Sori, Bow (sori = bow including the flattening effect of the weight of the wafer, bow = difference of the highest point of one wafer surface to the lowest one of the same wafer surface)

Wafer receiving boxes according to prior art have the problem, that they require a lot of space due to their geometric design such that the distance between two wire guide rollers of a wire saw has to be large enough to receive the wafer receiving box in between them. However, in order to keep the quality of the wafers as high as possible it has been found that the wire sections extending between the wire guide rollers should be as short as possible. In prior art wafer cutting systems in which the wafers are received during the cutting process in the wire saw (in-situ) the quality of the wafers is diminished by the fact that the distance between two wire guide rollers is too large having an adverse effect on holding the wire web in optimal position and tension.

The object of the present invention is to overcome these problems and to provide a wafer receiving box and a wafer cutting system allowing to minimize the distance between two wire guide rollers supporting the wire web. At the same time handling and functionality of the wafer receiving box should not be adversely affected.

This object is achieved by a wafer receiving box mentioned above wherein the wafer receiving box has in at least one further area which is adjacent to (i.e. above and/or below of) said first area at least one portion laterally extending beyond the width of said first area such that the width of the wafer receiving box in said further area is larger than the width of said first area.

The box has a first area and at least a further area which is wider than the first area. It is not necessary that the width of the further area(s) is constant in dependence of the height level of the box.

The invention allows to optimally use the space between the wire guide rollers, such that the distance between the wire guide rollers can be minimized. Due to the round cross section of the wire guide rollers the space in between them is not rectangular but has above and below the minimal distance between the wire guide rollers rounded corners. Due to the areas having different widths the wafer receiving box can at least partially be adapted to the not-rectangular space between the wire guide rollers. However, is it not necessary that the inventive box is symmetric.

The wafer receiving box has a long side defining its length and a broadside defining its width. The present invention refers to the contour of the broadside or to the shape of the cross section perpendicular to the long side, respectively.

The laterally extending (additional) portions define the deviation from rectangular shape. These portions build up the 'corners' of the broadside or cross section, respectively.

Laterally extending portions may be provided in a second area which is above said first area and/or laterally extending portions may be provided in a third area which is below said first area. 'Above' and 'below' indicate that the second and third area may be on opposite sides of the first area and refer to the way the wafer receiving box is normally oriented when used. The laterally extending portions each (the one above and the one below) may be on both sides of the box or only on one side.

In the case that lateral extending portions are provided above and below said first area, the broadside and/or the cross-section parallel to the broadside has (have) convex contours.

Preferably, the box is constructed from a base and sidewalls extending from that base upwardly thereby forming an enclosure for enclosing the volume inside. The top of the container has an opening for receiving the wafers from above.

When the wafers are received in the wafer receiving box the wafers are enclosed by the side walls and thus separated from the surrounding. The width of the first area is dimensioned such, that the wafers may be accommodated between the side walls of the box.

Preferably, even though not necessary, the portions are provided laterally on both sides of the wafer receiving box. With this embodiment the space between the wire web and both wire guide rollers can be optimally utilized.

Preferably, the laterally extending portions extend along the whole or most of the length of the wafer receiving box or of the wafer brick, when received by the wafer receiving box. The cross section perpendicular to the long side is almost constant and the portions may accommodate functional elements of the wafer receiving box.

Preferably, the laterally extending portions are bordered by the wall of the wafer receiving box. The portions are then integral part of the wafer receiving volume. The volume defined by the laterally extending portions is separated by the wall from external influences such as cutting and/or cooling fluid, dirt and/or chipping particles circulating in the wire saw. Also after cutting, e.g. during transport, the wafers are better protected. The side walls of the wafer receiving box enclose both, the wafers when being received and the laterally extending portions. This allows for a compact, space-saving and wafer-protecting construction.

Preferably, starting at the width of the first area the width of the wafer receiving box increases, preferably continuously, with increasing distance from the first area. This allows to optimally utilize the free space between wire guide rollers and at the same time allows cost-effective production. Preferably, the side wall of the wafer receiving box runs in a flat manner in the first area, then bends and continues to run in a inclined flat manner in the further (second and/or third) area.

Preferably, the cross section of the further area of the wafer receiving box has a trapezoidal shape. The cross section of the lateral extending portions, preferably, have a triangular or prismatic shape.

Preferably, the laterally extending portions accommodate a wafer-cooperating mechanism for acting upon the wafers when being received in the wafer receiving box, preferably for mechanically engaging with the wafers. Space can be exploited in an effective manner, if the portions accommodate functional elements. Although functional elements are provided the space between the wire guide rollers supporting the wire web can be kept very small.

The idea of this embodiment is to house as much functional elements as possible in the lateral extending portion(s). The narrower area should house as little functional elements as possible. Moreover, even if the functional elements extend in the narrowest part between the wire guide rollers, according to the invention the rollers can be brought together closer than according to the state of the art.

Preferably, the wafer-cooperating mechanism is a holding mechanism for laterally holding the wafers, wherein preferably the holding mechanism comprises holding members being movable between a release state and a holding state. The holding mechanism is used to hold the wafers during and/or after the cutting process, such that the wafers are held in an optimal parallel alignment, such that the gaps between individual wafers stays constant.

Preferably, the wafer-cooperating mechanism comprises detaching means for detaching the wafers from the beam, wherein preferably the detaching means is a fluid application mechanism for applying a fluid to the wafers and/or to the beam, for redirecting and blocking fluid flow, preferably fluid coming from the beam for de-gluing and/or wherein preferably the detaching means comprises an energy source, e.g. a heat source or an electromagnetic radiation source. This allows to de-glue and/or to detach the wafers from the beam within the wafer receiving box having integrated the appropriate functional ities.

Preferably, the wafer-cooperating mechanism is a displacing mechanism for displacing the wafers relative to walls of the wafer receiving box, preferably in a horizontal and/or vertical direction. In this context 'vertically' means essentially perpendicular to the wire web and 'horizontally' means essentially parallel to the wire web. The displacing mechanism may cooperate with the wafers such that the wafers are pulled downwards to separate them from the beam (sacrificial substrate). In such a way a counter-force to the gluing force may be applied. The displacing mechanism may comprise grippers which are movable towards the bottom of the wafer receiving box. The displacing mechanism may be e.g. needed for pulling the wafers from the beam to facilitate de-gluing.

Preferably, the laterally extending portions accommodate current conducting means for controlling the current flow of a fluid in the wafer receiving box.

Preferably, the laterally extending portions accommodate a reinforcement structure for making the wafer receiving box mechanically stiffer and/or more robust. This allows to construct all other parts of the box in a space-saving manner.

Preferably, the wafer receiving box is a fluid tight box, e.g. for retaining fluid during the cutting process.

The object is also achieved by a wafer cutting system for cutting an ingot into a plurality of wafers, the wafer cutting system comprising:
- a wire saw having a first wire guide roller rotatable about a first rotational axis, a second wire guide roller rotatable about a second rotational axis and a wire web supported by the wire guide rollers, wherein a minimal distance is defined between the wire guide rollers in the direction perpendicular to their rotational axes;
- a wafer receiving box according to one of the embodiments described above to be temporarily inserted in the wire saw for receiving the wafers during the cutting step, the width of the first area of the wafer receiving box being smaller than the minimal distance between the wire guide rollers, wherein in the inserted position the wafer receiving box is located between the wire guide rollers of the wire saw and extends with the width of its first area in the direction perpendicular to the rotational axes of the wire guide rollers;
wherein in the inserted position the first area of the wafer receiving box is situated at the level of the minimal distance between the wire guide rollers and the at least one further area is located distanced from the level of the minimal distance between the wire guide rollers.

The wafer receiving box and the wire saw are parts of the wafer cutting system. The wafer receiving box is adapted as to be inserted in the wire saw and to receive the wafers during the cutting step from above. The wafer receiving box can be removed with the cut wafers from the wire saw to transport them to another processing station (e.g. cleaning station).

Due to the laterally extending portions which are arranged distanced from the level of the minimal distance between the wire guide rollers the space enclosed by the wire guide rollers and the wire web can be optimally used. If required a security distance between the box and the wire guide rollers can be easily met, since the distance between the wire guide rollers also increases in upward and downward direction.

It is preferred to not approach the wire guide rollers too much with the wafer receiving box for security reasons. In a possible embodiment the maximal width of the at least one further area can therefore be not wider than the minimal distance between the wire guide rollers. However, also in such an embodiment the at least one further area is not placed at the level of the minimal distance between the wire guide rollers.

Preferably, the laterally extending portion of the wafer receiving box in the at least one further area extends beyond the minimal distance between the wire guide rollers such that the maximal width of the wafer receiving box in said further area is larger than the minimal distance between the wire guide rollers or larger than the minimal distance considering a minimal safety distance. This minimal safety distance ensures that the wire guide roller and it's functioning is not impaired by the vicinity of the wafer carrier. Also tolerances of the system need to be taken into account here. Typically, such minimal safety distance ensures a gap of at least 5 mm, preferably 15 mm on each side of the wafer carrier. The minimal safety distance may need to be kept in all areas of the wafer carrier.

Preferably, the laterally extending portion of the wafer receiving box in the at least one further area extends beyond the minimal distance between the wire guide rollers plus a safety distance such that the maximal width of the wafer receiving box in said further area is larger than the minimal distance plus the safety distance.

The laterally extending portions of the wafer receiving box project in the space between a wire guide roller and the wire web. The space below the wire web and between the wire guide roller is optimally utilized. The width of the first area is just slightly smaller than the minimal distance between the wire guide rollers.

It has to be understood that the minimal distance between the wire guide rollers and the width of the first area are measured in the same plain and in the same direction.

According to this embodiment it is possible to leave the space defined by the minimal distance (narrowest part) between the wire guide rollers free from functional, e.g. (movable) active members or the mechanism used for moving them. The space defined by the width of the first area can be completely used for receiving the wafers from above. It is of course possible, that e.g. the brushes used as holding members for holding the wafers may extend into the narrowest part. The idea of this embodiment is, that the wider area is used to house more active members for directly or indirectly cooperating with the wafers, and that the narrower area is used to house as little of these active members as possible, since it is dimensioned to mainly accommodate the wafers. The advantage of the inventive wafer receiving box is that the wire guide rollers can (almost) be placed as close together as the width of the wafers allow. Only the wall of the box runs between the narrowest point between the wire guide rollers and the wafers.

In that part of the box extending beyond the minimal distance between wire guide rollers (i.e. laterally extending portions) additional functional elements may be accommodated and/or mounted.

According to the invention it is not necessary to retrieve the wafers through the wire web, since the wafers are directly received by the wafer receiving box during cutting. Retrieving costs much force and sometimes damages the wafers.

The wafer receiving box may be easily moved to the wire saw in a direction which is essentially parallel to the rotational axes of the wire guide rollers. It is of course possible that a wire saw may have more than two wire guide rollers. The first and second wire guide rollers as described above hold the wire web through which the ingot is pushed through.

Preferably, the minimal distance between the wire guide rollers is larger than the maximal width of the wafer receiving box in said further area and/or wherein the difference between the minimal distance between the wire guide rollers and the maximal width of the wafer receiving box in said further area is smaller than approximately 30mm. This allows to meet a large security distance to the wire guide rollers. At the same time enough space is provided in the laterally extending portions to accommodate functional elements.

In another embodiment the maximal width of the wafer receiving box in said further area is larger than then 90% of the minimal distance between the wire guide rollers.

Preferably, the maximal width of the wafer receiving box in said further area is larger than 110% of the width of the first area, preferably larger than 115% of the width of the first area. This allows to accommodate in the laterally extending portions functional elements and to provide enough space for the wafers.

The object is also achieved by wafer cutting method for cutting an ingot into a plurality of wafers, the method comprising the steps of:
- inserting a wafer receiving box according to one of the embodiments described above in a wire saw to form a wafer cutting system as described above, wherein the wafer receiving box is inserted into the wire saw in a direction parallel to the rotational axes of the wire guide rollers of the wire saw,
- cutting an ingot by means of moving the ingot through the wire web,
- receiving the wafers by the wafer receiving box during the step of cutting.

When the wafers are received by the wafer receiving box this means that the wafers are at least partially located in the first area of the wafer receiving box. When the wafers are received it means that the wafers are in their final position after cutting. Normally, they are held in this position by clamping means or abutment means (e.g. rolls near bottom).

Preferably, the method further comprises the step of moving holding members of a holding mechanism which is accommodated in the laterally extending portions from a range between the upper and lower wire web, but outside of the space defined by the minimal distance (narrowest portion) between the wire guide rollers, as to engage and hold the wafers.

Preferably, the width of the first area is smaller than 120% of the width of the wafers.

The wire saw may also comprise a lower wire web, however, usually the upper wire web is used for cutting.

In the following a preferred embodiment is described. A wafer receiving box (carrier, container, etc.) is used to collect the wafers after having being sawn. The wafers are removed from the wire saw without being retracted thru the wire web. Moreover, they leave the wire saw thru an opening between the wire guide rollers, i.e. parallel to the rotational axes of the wire guide rollers.

The wafers may be held in the carrier by movable holding means that may engage the wafers from the side.

The widest part of the box is wider than the narrowest part between the wire guide rollers. This additional space is used for placing holders for the wafers.

In this way the distance between the wire guide rollers can be kept as small as possible which has a positive influence on the cut of the wafers. Moreover, since the wire extending between the rollers remains as short as possible, it is kept as straight as possible resulting in better wafer quality: TTV, saw marks, Sori and Bow.

The wafer carrier box can be retrieved from the wire saw as known in the state of the art. Also known ways can be used for retrieving wafer bricks from the wire saw without a wafer carrier such as in WO/2012/031900.

Further embodiments of the invention are indicated in the figures and in the dependent claims. The list of reference marks forms part of the disclosure. The invention will now be explained in detail by the drawings. In the drawings:
Fig. 1 shows a wire saw for cutting a plurality of wafers from an ingot,
Fig. 2 shows parallel arranged wafers after the cutting process,
Fig. 3 shows wafers after the cutting process with some of the wafers have fallen sideways (prior art),
Fig. 4 shows a wafer cutting system according to the invention comprising a wire saw and a wafer receiving box,
Fig. 5 shows a wafer receiving box and its geometrical dimensions,
Fig. 6 shows an embodiment of the wafer receiving box comprising a holding mechanism for holding wafers,
Fig. 7 shows an embodiment of the wafer receiving box comprising a fluid application mechanism for applying fluid onto the wafers,
Fig. 8 shows an embodiment of the wafer receiving box comprising an displacing mechanism.
Fig. 9 and 10 show embodiments of the wafer cutting system.

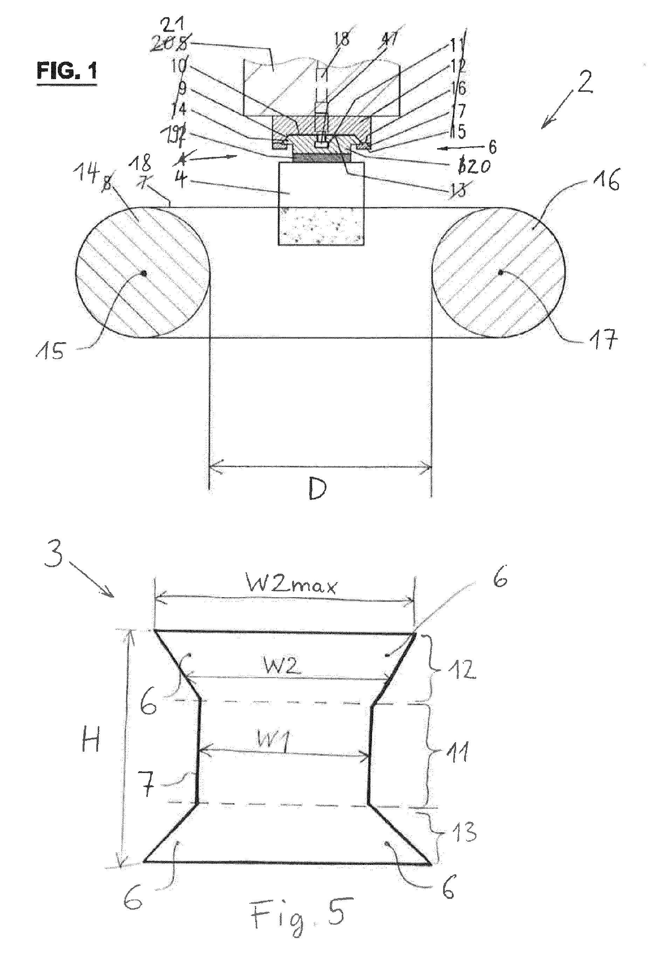

Fig. 1 shows a wire saw 2 for cutting a plurality of wafers from an ingot 4 (also called brick or core). The wire saw 2 comprises a support base 21 for positioning ingot 4 with respect to a wire web 18 which is formed by cutting wire. Ingot 4 is glued to a beam 19 (also called sacrificial substrate), which in turn is attached to a fixture attachment 20 usually made of metal. The beam 19 is mounted to the fixture attachment 20 which in turn is detachably mounted to the support base 21 of the wire saw 2.

Wire saw 2 further comprises wire guide rollers 14, 16 for forming a field of cutting wire, i.e. wire web 18.

After all cuts for separating the wavers 5 have been made (all wafers are cut in parallel), the wafers 5 are still attached to the beam 8 giving the wafer block a comb-like structure.

During the cutting process, the ingot 4 is pushed through the wire web 18, causing the cutting wire to bend downwards (not shown). Because of this bow of the cutting wire, the top edges of the ingot are cut before the middle part of the ingot is completely cut. It is the purpose of the sacrificial substrate or beam 19 to keep the fixture attachment 20 at a distance of the ingot 4, so that the fixture attachment 20 is not cut. The beam 19 - which is relatively inexpensive - is replaced after each cut.

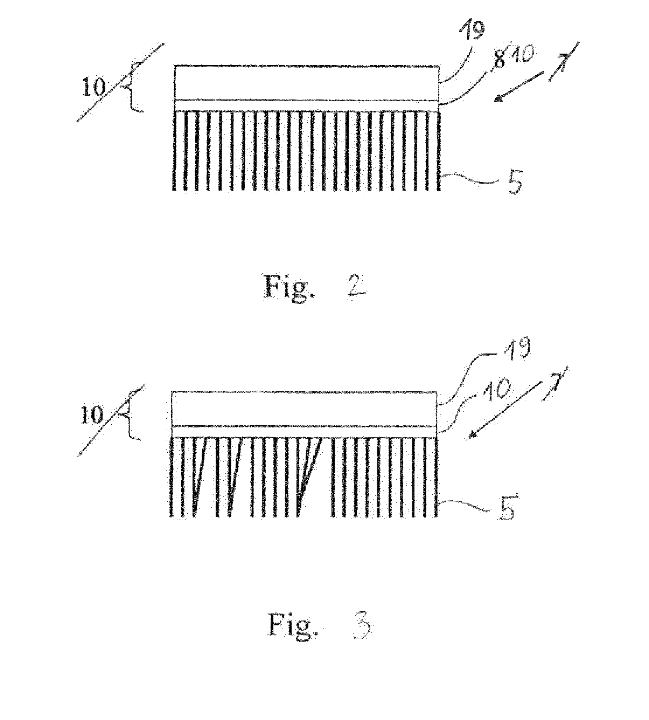

Once the wafers have been cut, they have to be cleaned and separated from the beam 19. Ideally, the arrangement of a plurality of wafers 5 still hanging on the beam 19 via a gluing layer 10 corresponds to the drawing of Fig. 2. All wafers 5 are aligned in parallel with a constant spacing between the individual wafers. However, the wafers 5 are very thin and easily damaged. One can imagine, that if the fixture attachment 20 is tilted or pushed, the wafers move sideward and stick to each other due to the fluid on their respective surfaces forming the spacing between them. Fig. 3 illustrates this non-ideal situation.

After the ingot has been cut, the wafers are dirty from the slurry or cutting fluid and the silicon particles that are cut off (swarf). If the wafers are left to dry, the swarf gets stuck to the wafers are very hard to remove. Also the wafers become stains that are not allowable. For both reasons, wafers are cleaned right after they have been cut, not allowing them to dry while dirty.

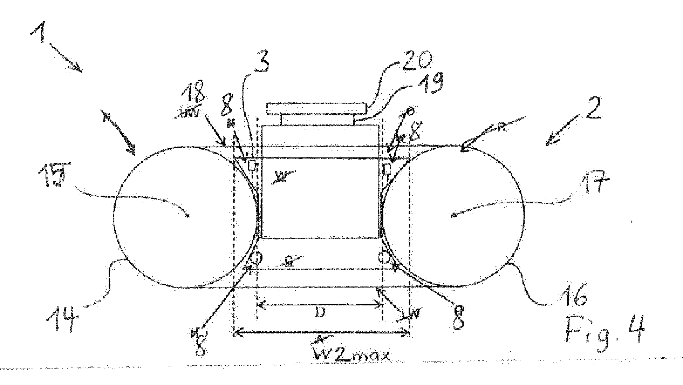

Fig. 4 shows a wafer cutting system 1 for cutting an ingot 4 into a plurality of wafers 5 according to the invention. The wafer cutting system 1 comprises a wire saw 2 having a first wire guide roller 14 rotatable about a first rotational axis 15, a second wire guide roller 16 rotatable about a second rotational axis 17 and a wire web 18 supported by the wire guide rollers 14, 16, wherein a minimal distance D is defined between the wire guide rollers 14, 16 in the direction perpendicular to their rotational axes 15, 17.

The wafer cutting system 1 further comprises a wafer receiving box 3 to be temporarily inserted in the wire saw 2 for receiving the wafers 5 during the cutting step. The box 3 - also shown in Fig. 5 - has in a first area 11 a width W1 and in a second and third area 12, 13 which are above and below said first area 11 portions 6 laterally extending beyond the width W1 of said first area 11 such that the width W2 of the wafer receiving box 3 in said second and third area 12, 13 is larger than the width W1 of said first area 11. As can be seen from Fig. 4 and 5, the width W2 of the further areas 12, 13 increases continuously in dependence of the distance from said first area 11 and reaches a maximal width W2max.

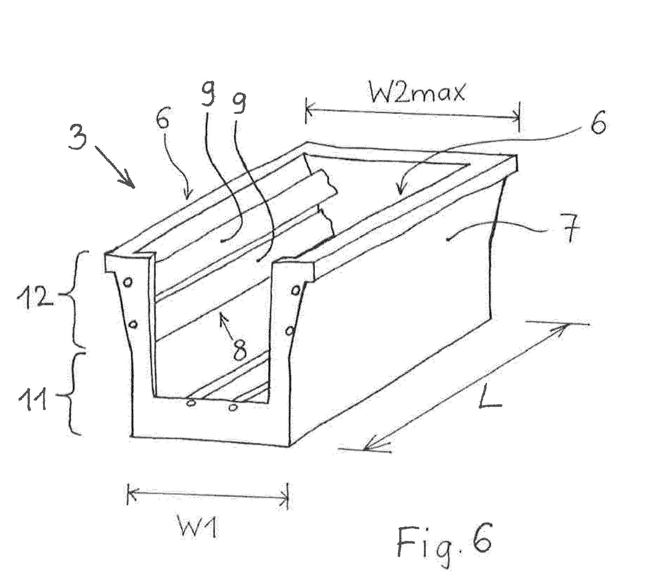

The width W1 of the first area 11 of the wafer receiving box 3 is slightly smaller than the minimal distance D between the wire guide rollers 14, 16 of the wire saw 2. Preferably, the width W1 it is significantly smaller than the maximal width W2max. According to the embodiment of Fig. 6 holding members 9 may extend in or very close to the first area 11 where the wire guides rollers 14, 16 are closest together, but they extend beyond this width as the elaborate mechanism to move them is placed in the second and third areas 12, 13.

In the inserted position in the wire saw, the wafer receiving box 3 is located between the wire guide rollers 14, 16 of the wire saw 2 and extends with the width W1 of its first area 11 in the direction perpendicular to the rotational axes 15, 17 of the wire guide rollers 14, 16. I.e. the broadside of the box 3 is perpendicular to the rotational axes 15, 17. Fig. 5 further indicates the height H of box 3.

Preferably, box 3 is built up by a bottom plate and side walls 7 extending from said bottom plate.

As can be seen from Fig. 4, the laterally extending portions 6 of the wafer receiving box 3 in the further areas 12, 13 extends beyond the minimal distance D between the wire guide rollers 14, 16 such that the maximal width W2max of the wafer receiving box 3 in said further areas 12, 13 is larger than the minimal distance D between the wire guide rollers 14, 16.

Box 3 is dimensioned such that it fits below the wire web 18 and between the wire guide rollers 14, 16.

Fig. 6 shows an embodiment of a wafer receiving box 3 having in a first area 11 a width W1 and a second area 12 above the first area 11. Contrary to the embodiment of Fig. 4 and 5, the box of Fig. 6 has no third area with a larger width below said first area 11. In this embodiments near the bottom of the wafer receiving box 3 supports are provided for the wafers to rest on.

The portions 6 are provided laterally on both sides of the wafer receiving box 3, extend along the whole length L of the wafer receiving box 3 and are bordered by the wall 7 of the wafer receiving box 3. The portions 6 are thus integral part of the wafer receiving box volume.

Starting at the width W1 of the first area 11 the width of the wafer receiving box 3 increases continuously (here linearly) with increasing distance from the first area 11. The cross section of the second area 12 of the wafer receiving box 3 has a trapezoidal shape. The cross section of the laterally extending portions 6 has triangular shape.

The laterally extending portions 6 accommodate a wafer-cooperating mechanism for mechanically engaging with the wafers 5 in form of a holding mechanism 8 for laterally holding the wafers 5. The holding mechanism 8 comprises holding members 9 being movable between a release state and a holding state. As indicated previously, such holding means are known from the state of the art and may or may not be movable.

According to a preferred wafer cutting method, the holding members 9 of the holding mechanism 8 are moved out from the laterally extending portions 6 towards the wafers 5 as to engage and hold the wafers 5, e.g. after the cutting process and for transport purposes. They may also engage the wafers with lesser force during cutting to ensure that the wafer do not stick to each other.

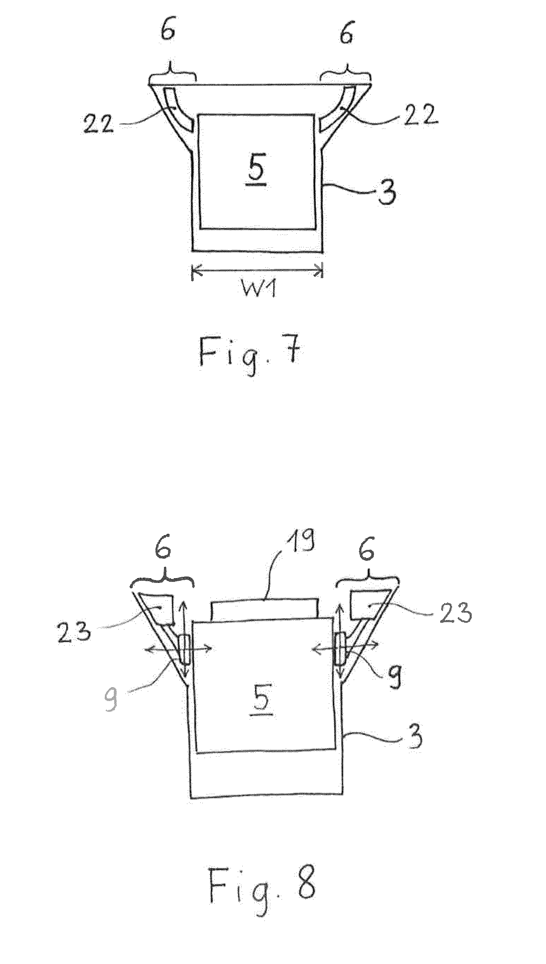

In Fig. 7 an embodiment of the wafer receiving box 3 is shown with a fluid application mechanism 22, e.g. in form of at least one nozzles or at least one fluid inlet. The fluid application mechanism 22 is mainly accommodated in the laterally extending portions 6. The fluid application mechanism 22 is also understood as wafer cooperating mechanism, since it wets the wafers 5 and/or directs fluid 5 (e.g. cleaning fluid, cutting fluid and/or de-gluing fluid) onto the wafers and thus indirectly interacts with the wafers 5.

Alternatively, the wafer-cooperating mechanism may be a displacing mechanism 23 for displacing the wafers 5 relative to walls 7 of the wafer receiving box 3 (Fig. 8). As can be seen from Fig. 8 the holding members 9 of the displacing mechanism 23 mechanically engaging the wafers 5 may be movable in lateral directions and/or in vertical direction, such that the wafers 5 can be moved within the wafer receiving box 3. The displacing mechanism 23 is mainly accommodated in the laterally extending portions 6. The displacing mechanism 23 may be provided additionally to the holding mechanism 8 and may be used to release the wafers 5 from the beam 19.

In a further embodiment the laterally extending portions 6 may accommodate current conducting means for controlling the current flow in the wafer receiving box. It may comprise connectors of a fluid inlet or outlet. It may also simply comprise an opening for letting fluid into and out of the wafer receiving box.

It is also possible that the laterally extending portions 6 accommodate a reinforcement structure for making the wafer receiving box 3 mechanically stiffer and/or more robust, e.g. in form of reinforcement bars, strut members, framework, etc.

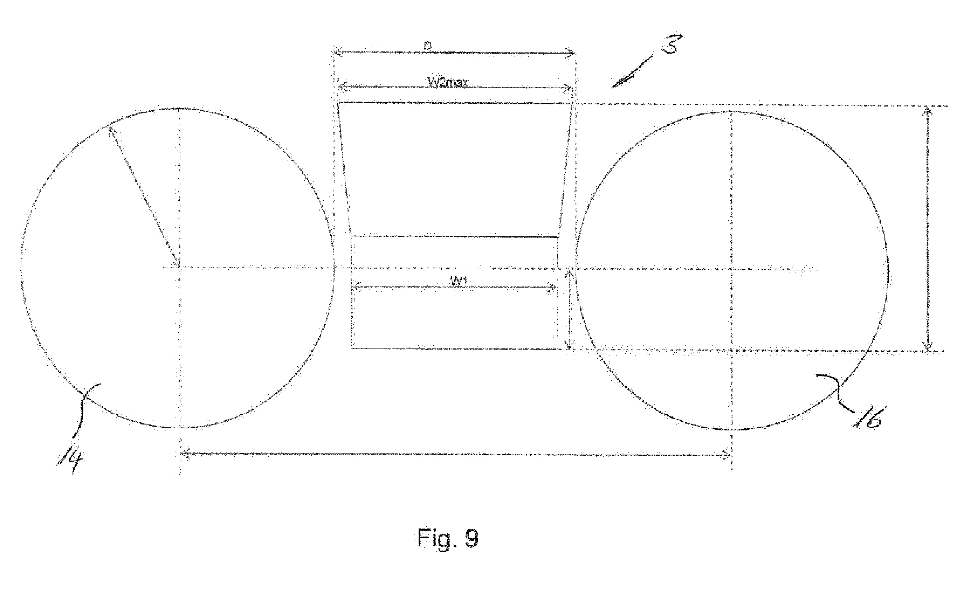

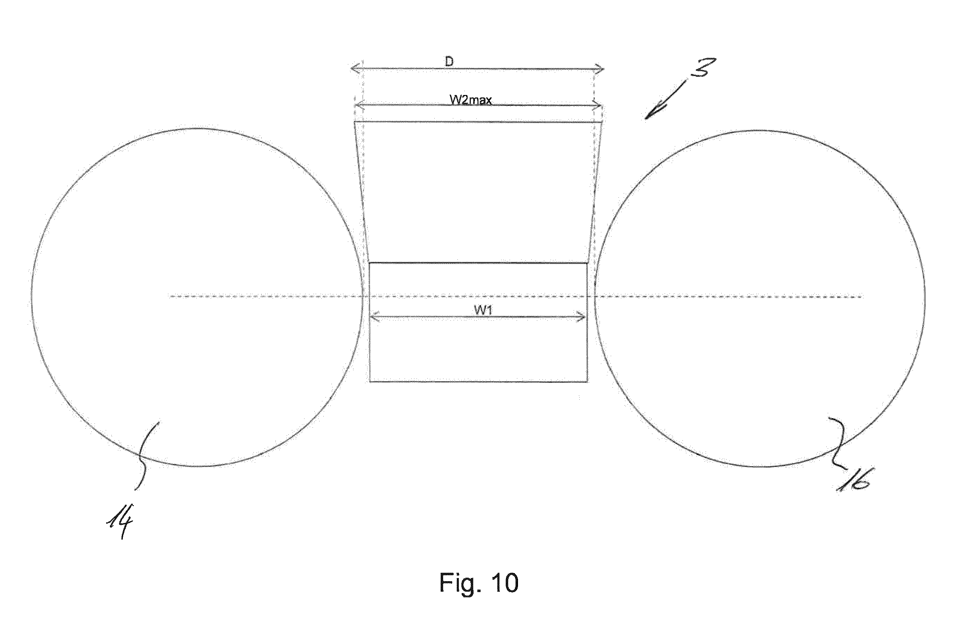

Fig. 9 and Fig. 10 show embodiments of the wafer receiving box 3. In the embodiment of Fig. 9 the maximal width W2max of the further area is smaller than the minimal distance D.

In the embodiment of Fig. 10 the maximal width W2max of the further area is larger than the minimal distance D between the wire guide rollers.

The invention is not restricted to these embodiments. Other variants will be obvious for the person skilled in the art and are considered to lie within the scope of the invention as formulated in the following claims.

### List of reference marks

- 1: wafer cutting system
- 2: wire saw
- 3: wafer receiving box
- 4: ingot
- 5: wafers
- 6: laterally extending portion
- 7: wall of the wafer receiving box 1
- 8: holding mechanism
- 9: holding member
- 10: gluing layer
- 11: first area
- 12: second area
- 13: third area
- 14: first wire guide roller
- 15: rotational axis of the first wire guide roller
- 16: second wire guide roller
- 17: rotational axis of the second wire guide roller
- 18: wire web
- 19: beam
- 20: fixture attachment
- 21: support base
- 22: fluid application mechanism
- 23: displacing mechanism
- H: height of the wafer receiving box 1
- L: length of the wafer receiving box 1
- W1: width of the wafer receiving box 1 in a first area 11
- W2: width of the wafer receiving box 1 in a further area 12, 13
- W2: max maximal width of the wafer receiving box 1 in a further area 12, 13

## Claims

1. Wafer receiving box (3) for receiving wafers (5), the wafer receiving box (3) having in a first area (11) a width (W1), **characterized in that** the wafer receiving box (3) has in at least one further area (12, 13) which is adjacent to said first area (11) at least one portion (6) laterally extending beyond the width (W1) of said first area (11) such that the width (W2) of the wafer receiving box (3) in said further area (12, 13) is larger than the width (W1) of said first area (11).

2. Wafer receiving box according to claim 1, **wherein** the portions (6) are provided laterally on both sides of the wafer receiving box (3).

3. Wafer receiving box according to claim 1 or 2, **wherein** the laterally extending portions (6) are bordered by the wall (7) of the wafer receiving box (3).

4. Wafer receiving box according to one of the claims 1 to 3, **wherein** starting at the width (W1) of the first area (11), the width (W) of the wafer receiving box (3) increases, preferably continuously, with increasing distance from the first area (11), wherein preferably the cross section of the further area (12, 13) of the wafer receiving box (3) has a trapezoidal shape.

5. Wafer receiving box according to one of the claims 1 to 4, **wherein** the laterally extending portions (6) accommodate a wafer-cooperating mechanism for acting upon the wafers (5) when being received in the wafer receiving box (3), preferably for mechanically engaging with the wafers (5).

6. Wafer receiving box according to claim 5, **wherein** the wafer-cooperating mechanism comprises a holding mechanism (8) for laterally holding the wafers (5), wherein preferably the holding mechanism (8) comprises holding members (9) being movable between a release state and a holding state.

7. Wafer receiving box according to claim 5 or 6, **wherein** the wafer-cooperating mechanism comprises detaching means for detaching the wafers (5) from the beam (19), wherein preferably the detaching means is a fluid application mechanism (22) for applying a fluid to the wafers (5) and/or to the beam (19) and/or a displacing mechanism (23) for displacing the wafers (5) relative to walls (7) of the wafer receiving box (3), preferably in a horizontal and/or vertical direction, and/or wherein preferably the detaching means comprises an energy source, e.g. a heat source or an electromagnetic radiation source.

8. Wafer receiving box according to one of the claims 1 to 7, **wherein** the laterally extending portions (6) accommodate current conducting means for controlling the current flow of a fluid in the wafer receiving box (3) and/or a fluid inlet or a fluid outlet.

9. Wafer receiving box according to one of the claims 1 to 8, **wherein** the laterally extending portions (6) accommodate
- a reinforcement structure for making the wafer receiving box (3) mechanically stiffer and/or more robust,
- and/or a structure for handling or positioning of the wafer receiving box (3),
- and/or means for operating the wafer-cooperating mechanism or current conducting means.

10. Wafer cutting system (1) for cutting an ingot (4) into a plurality of wafers (5), the wafer cutting system (1) comprising:
- a wire saw (2) having a first wire guide roller (14) rotatable about a first rotational axis (15), a second wire guide roller (16) rotatable about a second rotational axis (17) and a wire web (18) supported by the wire guide rollers (14, 16), wherein a minimal distance (D) is defined between the wire guide rollers (14, 16) in the direction perpendicular to their rotational axes (15, 17);
- a wafer receiving box (3) according to one of the claims 1 to 9 to be temporarily inserted in the wire saw (2) for receiving the wafers (5) during the cutting step, the width (W1) of the first area (11) of the wafer receiving box (3) being smaller than the minimal distance (D) between the wire guide rollers (14, 16), wherein, in the inserted position, the wafer receiving box (3) is located between the wire guide rollers (14, 16) of the wire saw (2) and extends with the width (W1) of its first area (11) in the direction perpendicular to the rotational axes (15, 17) of the wire guide rollers (14, 16);
wherein, in the inserted position, the first area (11) of the wafer receiving box (3) is situated at the level of the minimal distance (D) between the wire guide rollers (14, 16) and the at least one further area (12, 13) is located distanced from the level of the minimal distance (D) between the wire guide rollers (14, 16).

11. Wafer cutting system according to claim 10, **wherein** the laterally extending portion (6) of the wafer receiving box (3) in the at least one further area (12, 13) extends beyond the minimal distance (D) between the wire guide rollers (14, 16) such that the maximal width (W2max) of the wafer receiving box (3) in said further area (12, 13) is larger than the minimal distance (D) between the wire guide rollers (14, 16),
**or wherein** the laterally extending portion (6) of the wafer receiving box (3) in the at least one further area (12, 13) extends beyond the minimal distance (D) between the wire guide rollers (14, 16) plus a safety distance such that the maximal width (W2max) of the wafer receiving box (3) in said further area (12, 13) is larger than the minimal distance (D) plus the safety distance.

12. Wafer cutting system according to claim 10, **wherein** the minimal distance (D) is larger than the maximal width (W2max) of the wafer receiving box (3) **and/or wherein** the difference between the minimal distance (D) between the wire guide rollers (14, 16) and the maximal width (W2max) of the wafer receiving box (3) in said further area (12, 13) is smaller than approximately 30mm.

13. Wafer cutting system according to one of the claims 10 to 12, **wherein** the maximal width (W2max) of the wafer receiving box (3) in said further area (12, 13) is larger than 110% of the width (W1) of the first area (11), preferably larger than 115% of the width (W1) of the first area (11).

14. Wafer cutting method for cutting an ingot (4) into a plurality of wafers (5), the method comprising the steps of:
- inserting a wafer receiving box (3) according to one of the claims 1 to 9 in a wire saw (2) to form a wafer cutting system (1) according to claim 12, wherein the wafer receiving box (3) is inserted into the wire saw (2) in a direction essentially parallel to the rotational axes (15, 17) of the wire guide rollers (14, 16) of the wire saw (2),
- cutting an ingot (4) by means of moving the ingot through the wire web (18),
- receiving the wafers (5) by the wafer receiving box (3) during the step of cutting.

15. Wafer cutting method according to claim 14,
**wherein** the wafer receiving box (3) is a wafer receiving box according to claim 7 and the ingot (4) is attached to a beam (19) during the step of cutting, the method further comprising the step of:
- moving a holding member (9) of the holding mechanism (8) out of the at least one laterally extending portion (6) towards the wafers (5) as to engage and hold the wafers (5) and/or as to detach them from the beam (19).
**and/or wherein** the width (W1) of the first area (11) is smaller than 120% of the width of the wafers (5).
